# EUROPEAN PATENT SPECIFICATION

(11) **EP 3 701 277 B1**
(45) Date of publication and mention of the grant of the patent: **16.10.2024**
(21) Application number: 18801140.7
(22) Date of filing: 23.10.2018
(51) Int. Cl.: G01R 31/36, G01R 31/392

(54) **USER INTERFACE FOR A BATTERY TESTER**
BENUTZERSCHNITTSTELLE FÜR EINEN BATTERIETESTER
INTERFACE UTILISATEUR POUR UN TESTEUR DE BATTERIE

(30) Priority: 23.10.2017 US 201762575960 P; 30.10.2017 US 201762578974 P
(43) Date of publication of application: 02.09.2020
(73) Proprietor: CPS Technology Holdings LLC, New York, New York 10281 (US)
(72) Inventor: FRIGO, Clare, Pewaukee WI 53072 (US); GOSPODAREK, Dale, Kenosha WI 53144 (US); ROBERTS, Julie, Cedarburg WI 53012 (US); FRIAS, Itziar, Milwaukee WI 53222 (US); CHERRY, Kenneth, B., Lawrenceville GA 30044 (US); SCHECK, David, Schaumburg IL 60193 (US); SALO, Andrew, J. III, Chicago IL 60618 (US); SPANG, Sarah, Chicago IL 60614 (US); SWEENEY, Ryan, Chicago IL 60647 (US)
(74) Representative: Meissner Bolte Partnerschaft mbB
(86) International application number: PCT/US2018/057140
(87) International publication number: WO 2019/084031

(56) References cited:
- EP-A1- 3 226 015
- US-A1- 2008 224 710
- US-A1- 2010 010 702
- US-A1- 2016 077 159
- US-A1- 2017 177 054
- US-B2- 9 595 140

## Description

This application claims priority to United States Provisional Patent Application Numbers 62/575,960 filed October 23, 2017 and 62/578,974 filed October 30, 2017.

### FIELD

This application relates to battery testers. More specifically, this application relates to a user interface for a battery tester.

### BACKGROUND

A battery tester may be used in a number of scenarios. It may be used on a battery installed in a vehicle, a battery removed from a vehicle, or a new battery.

Known battery testers have two cables: a positive and a negative cable, which are attached to the battery's positive and negative terminal. The battery tester uses these connected cables to perform a series of tests on the vehicle. The tests are then used to produce a report, typically regarding battery state of charge and/or health. The battery tester is typically operated by a technician.

Known testers have user interfaces with a number of disadvantages. For example, known testers may have user interfaces that are difficult to navigate when connected to a battery. Known testers may have user interfaces that only work with large, horizontal screens, requiring cumbersome tester positioning. Other known testers may have physical button-based navigation with small mono-color screens; others may require printouts to display testing results.

Known testers may therefore have user interfaces that are difficult to navigate and obtain results. What is needed is a battery tester user interface that remedies these and other deficiencies.

The document US 2016/0077159 A1 relates to a system for monitoring battery status and estimating battery life including a battery monitor configured to connect to a battery. The battery monitor comprises a voltage detection circuit, a temperature sensor and a wireless transmitter configured to transmit voltage and temperature data measured by the voltage detection circuit and the temperature sensor.

The document EP 3 226 015 A1 relates to a wireless battery management system and method of operating the same. The wireless battery management system includes at least one battery tester that is electrically connected to at least one battery unit. The wireless terminal apparatus includes a wireless communication unit, a display unit, and a user interface.

The document US 2017/0177054 A1 relates to a portable electronic device having a user interface for displaying battery usage of the device over a given time period, with the battery usage from various subsystems.

The document US 9,595,140 B2 relates to a graphical user interface that can be used on a diagnostic tool. The graphical user interface allows a technician to operate various functions of the diagnostic tool.

The document US 2010/0010702 A1 relates to a diagnostic tool and a computer-implemented method for generating testing and diagnosis procedures for vehicle diagnosis including determining if a first procedure remains to be performed, if a first procedure remains to be performed, then determining whether: there is a second procedure dependent on the first procedure, or the first procedure can run in parallel to the second procedure, if there is a second procedure dependent on the first procedure, then performing the first procedure, if the first procedure can run in parallel to the second procedure, then performing the first procedure, and determining if the second procedure remains to be performed.

US 2008/224710 discloses an handheld battery tester including two tester cables attached to a housing. An user interface including a screen and buttons allows for one-handed interaction with the user interface.

### SUMMARY OF THE INVENTION

The present invention relates to a battery tester according to independent claim 1, wherein further developments of the inventive battery tester are provided in the sub-claims 2 to 7, respectively. The present invention further relates to a method for battery health data capture and display according to claim 8, wherein further developments of the inventive method are provided in the sub-claims 9 to 11, respectively.

Disclosed is a battery tester user interface that seeks to remedy the above and other deficiencies.

According to the present invention, the battery tester user interface is vertically-oriented (i.e. portrait orientation). The orientation may facilitate ease of operation of the battery tester by a technician by allowing for one-handed interaction with the interface. This may allow for improved ability to perform the testing-in other words, the technician may hold the device in one hand and perform physical testing with the other. In addition, the user interface may be configured for display on a touch screen, allowing for ease of access throughout testing.

The battery tester user interface according to various embodiments of the invention may include improved navigation features. For example, the interface may allow for elements to be displayed in a single, more easily-navigable screen during testing. According to the present invention, the user interface is vertically oriented to allow for ease of navigation while a tester is held.

As another non-limiting example, the interface may allow for single-touch access to multiple testing aspects. The user interface may allow for easily navigable display of a large amount of information. According to the present invention, the user interface comprises a three-stage top navigation for displaying testing results, which allows for quick and easy navigation to relevant battery health and battery test data.

Disclosed is a battery tester comprising a computing device and a screen, the computing device being configured to display on the screen a user interface for improved battery testing, the user interface comprising a series of interfaces: a first interface comprising a plurality of icons, each of the plurality of icons corresponding to at least one of a test condition or a tester functionality; a testing interface comprising a number of instructions which update based on a user interaction with the vehicle, and wherein selection of an icon in the first interface corresponding to a test condition displays the testing interface; and a results interface, having a three-stage top navigation and summary, the three-stage top navigation for reporting battery health metrics, wherein completion of the testing interface displays a results interface. Further disclosed is a battery tester wherein the one or more of the top navigation comprises a cranking result or a charging result. Further disclosed is a battery tester wherein selection of one or more of the three-stage navigation presents a battery replacement recommendation. Further disclosed is a battery tester wherein selection of one of the three-stage navigation provides a testing results summary interface. Further disclosed is a battery tester wherein viewing of the testing results summary interface may be achieved by scrolling downward on the tester user interface. Further disclosed is a battery tester comprising a vehicle record interface, the vehicle record interface having a plurality of fields for inputting vehicle information, wherein the interface may be populated by a user or tester-obtained data. According to the present invention, the battery tester is sized to be held one-handed.

Disclosed is a method for improved battery health data capture and display, the method comprising: holding a battery tester, the battery tester having a screen displaying a user interface; selecting one of a plurality of icons displayed on the user interface corresponding to a test condition to begin a test; displaying on the user interface a testing interface which dynamically updates based on the completion of one or more testing steps; upon completion of one or more tests, displaying on the user interface a results interface having a three-stage top navigation and health summary, the three-stage top navigation corresponding to different battery health information; selecting on the user interface one or more of the three-stage top navigation to display a results summary and recommendation regarding battery health. Further disclosed is a method further comprising populating on the user interface a vehicle information interface, the vehicle information interface optionally being populated by manual entry. According to the present invention, the battery tester is sized to be held in one hand and the user interface is vertically-oriented. Further disclosed is a method wherein the battery tester screen is a touchscreen. Further disclosed is a method wherein one of the three-stage top navigation comprises a cranking result. Further disclosed is a method wherein selection of one or more of the three-stage navigation presents a battery replacement recommendation. Further disclosed is a method wherein selection of one of the three-stage top navigation provides a testing results summary interface.

Disclosed herein is a method for displaying battery health information on a graphical user interface, the method comprising: providing a touchscreen on a battery tester, the touchscreen displaying a user interface; displaying on the user interface a testing interface which dynamically updates with testing instructions based on the completion of one or more testing steps; upon completion of one or more tests, displaying on the user interface a results interface having a three-stage top navigation and health summary, the three-stage top navigation corresponding to different battery health metrics; selecting on the user interface one or more of the three-stage top navigation to display a testing results summary and recommendation regarding battery health. According to the present invention, the battery tester is sized to be held in one hand and the user interface is vertically-oriented. Further disclosed is a method wherein one of the three-stage top navigation comprises a cranking result.

In summary, the disclosed battery tester user interface and method allows for improved ease of operation and display of information over known battery testers. These and other advantages are disclosed further herein.

### BRIEF DESCRIPTION OF THE FIGURES

Fig. 1 shows a battery tester having a user interface, according to one or more embodiments.
Fig. 2 shows a battery tester having a user interface being held by a user, according to one or more embodiments.
Fig. 3 shows another embodiment of a battery tester having a user interface, according to one or more embodiments.
Fig. 4 shows a second view of a battery tester of FIG. 3 having the user interface, according to one or more embodiments.
Figs. 5A-5C show a battery tester user interface display showing an unlocking interface, according to one or more embodiments.
Fig. 6 shows a battery tester user interface display showing a navigation interface, according to one or more embodiments.
Fig. 7 shows a battery tester user interface display showing a vehicle information interface, according to one or more embodiments.
Figs. 8A-8B show a battery tester user interface display showing a vehicle information interface, according to one or more embodiments.
Figs. 9A-9B show a battery tester user interface display showing a battery information interface, according to one or more embodiments.
Fig. 10 shows a battery tester user interface display showing a testing instruction interface, according to one or more embodiments.
Fig. 11 shows a battery tester user interface display showing a cranking results interface, according to one or more embodiments.
Fig. 12 shows a battery tester user interface display showing a charging results interface, according to one or more embodiments.
Fig. 13 shows a battery tester user interface display showing a testing results interface, according to one or more embodiments.
Fig. 14 shows a battery tester user interface display showing another view of a testing results interface, according to one or more embodiments.
Figs. 15A-B show a battery tester user interface display showing another view of a testing results interface, according to one or more embodiments.
Fig. 16 shows a battery tester user interface display another view of a testing results interface, according to one or more embodiments.
Figs. 17A-B show a battery tester user interface display, according to one or more embodiments.
Figs. 18A-D show a battery tester user interface display, according to one or more embodiments.
Fig. 19 shows a front and back of a battery tester having a user interface display according to one or more embodiments.
Fig. 20 shows a battery tester user interface method according to one or more embodiments.
Figs. 21A-21B show a battery tester user interface display including a settings interface, according to one or more embodiments.

It should be understood that the drawings are not necessarily to scale. In certain instances, details that are not necessary to the understanding to the invention or render other details difficult to perceive may have been omitted. It should be understood, of course, that the invention is not necessarily limited to the particular embodiments illustrated herein.

### DESCRIPTION OF THE INVENTION

Turning to the Figures, a battery tester user interface according to various examples of embodiments is disclosed. Also disclosed is a method of operation and navigation facilitated by the battery tester user interface according to various examples of embodiments.

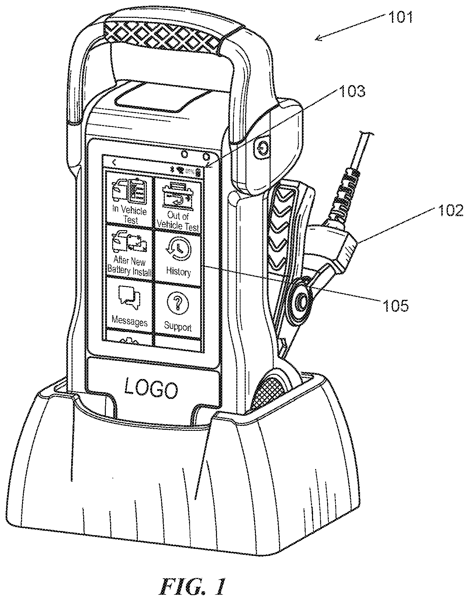

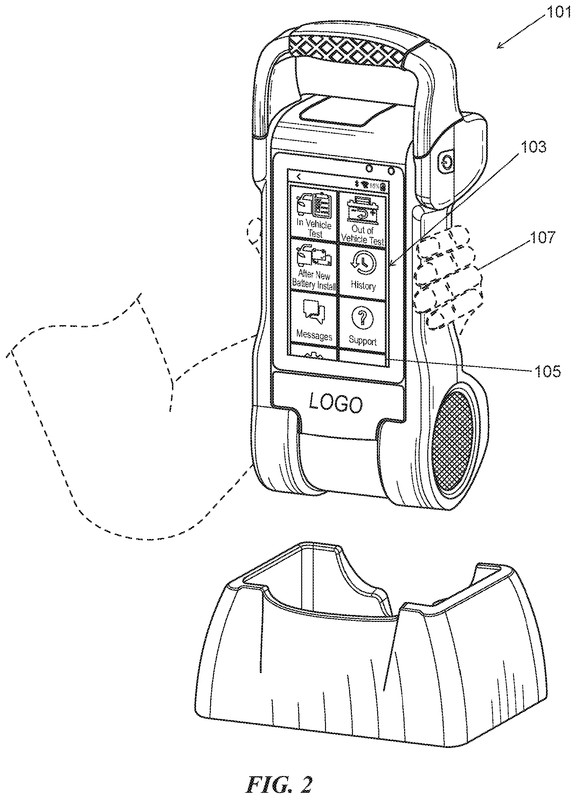

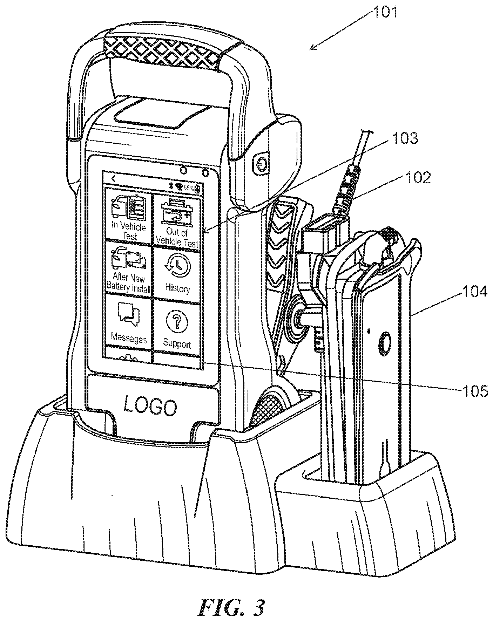

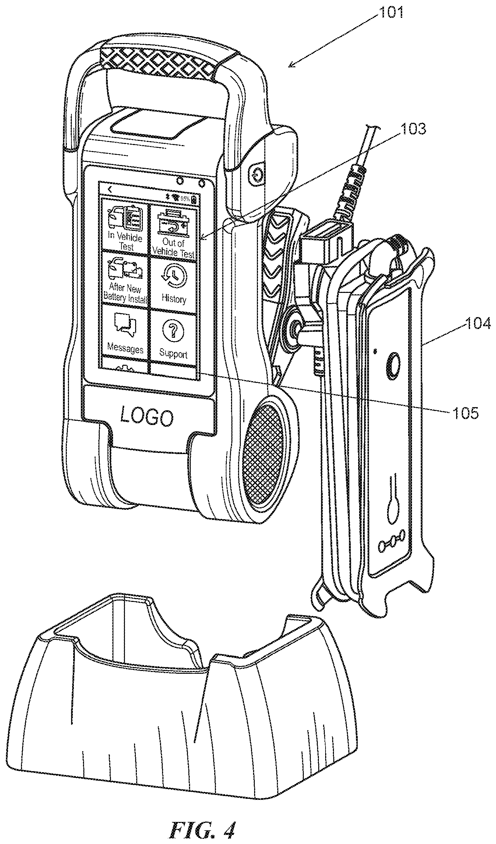

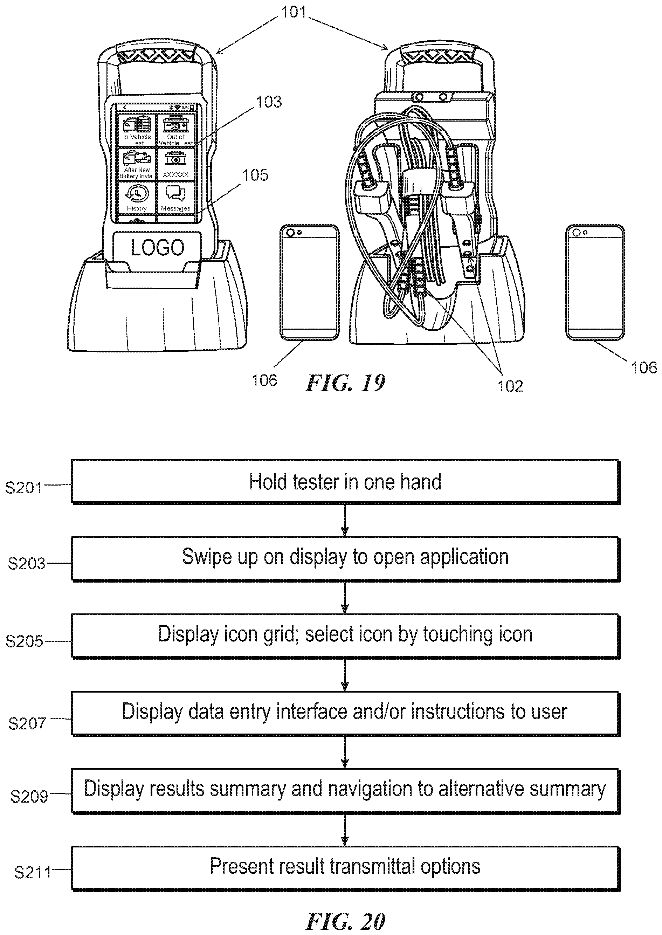

In Figs. 1-4, a battery tester 101 having a user interface 105 according to various examples of embodiments is disclosed. According to the present invention, the battery tester 101 is sized to be gripped by a single hand 107 (see Fig. 2). The battery tester 101 is held, for example, such that a thumb could grip one side and fingers the other, with the back of the hand cradling the back of the tester and leaving the front display 103 (which may comprise a touchscreen) featuring the user interface 105 exposed. An example of a hand 107 holding a battery tester 101 according to various examples of embodiments can be seen in Fig. 2. As can be seen in Figs. 1 and 19 and according to the present invention, the tester 101 comprises two tester cables 102 for positive and negative connections. In addition, as shown in Fig. 3 and Fig. 4, the tester may have one or more holder(s) and one or more peripheral device(s) 104.

As can be readily ascertained, the battery tester 101 comprises a screen or display 103 on a front of the tester. The display 103 may be a touch-sensitive screen. The front of the battery tester 101 may not have traditional, tactile "buttons." Instead, testing according to one or more examples of embodiments is navigated using the display 103 featuring the user interface 105. However, in alternative embodiments, the front of the tester 101 may comprise one or more tactile buttons. According to the present invention, the screen 103 is vertically oriented on the battery tester 101. The vertical orientation allows the battery tester to advantageously feature more area for the screen while allowing the user to hold the tester. The vertically-oriented user interface allows for ease of operation of the battery tester while held in a technician's hand. For example, the battery tester 101may be held and operated via the user interface 105 while accessing a battery for testing (for example, a battery for use with a vehicle, the battery being accessed for testing in various embodiments inside or outside of the vehicle).

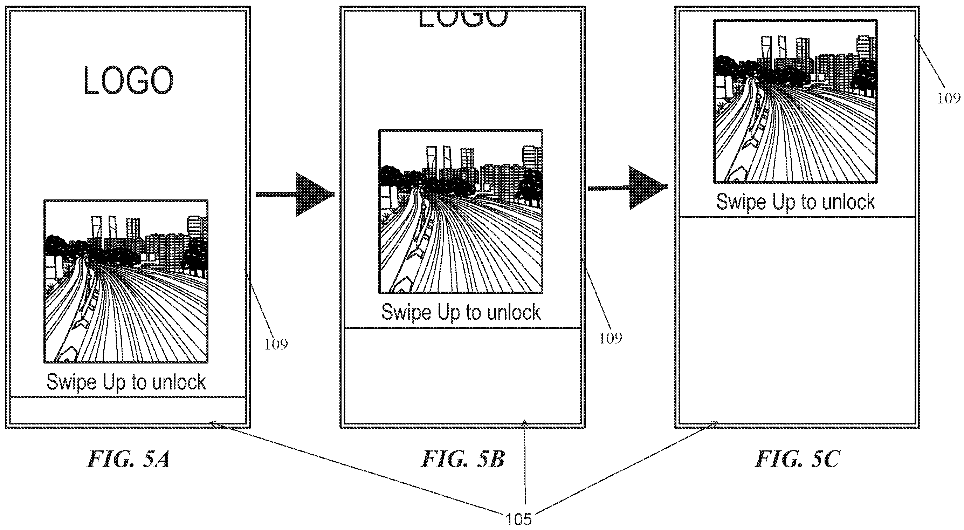

In Figs. 5A-5C, a first user interface 105 display screen is shown. The user interfaces shown herein may be understood to show a display of a screen 103 having a user interface 105 as it is oriented on a battery tester 101 (i.e. in a vertical orientation on a vertical screen provided on the battery tester). Alternative gestures, such as side swipe or tapping, are contemplated as within the scope of this disclosure.

Moving from Fig. 5A to Fig. 5B to Fig. 5C, the figures show the user interface 105 having an unlocking interface 109 which changes as the result of a motion of swiping towards a top of the page to launch or unlock the device. In various embodiments, the user may drag his or her finger from a bottom portion of the interface screen toward an upper or top portion of the screen. By interacting with the screen 103 of the battery tester 101 in this way, access to tester functionality, for example, battery testing may begin.

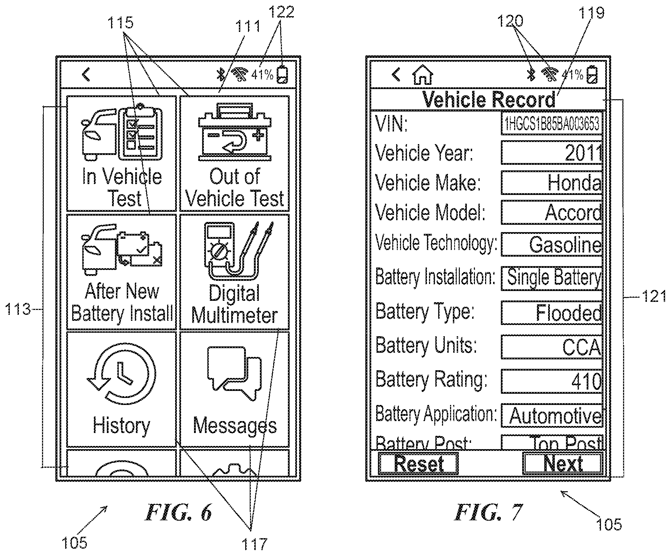

Fig. 6 shows the user interface 105, particularly a menu interface 111, featuring a number of icons 113. In the illustrated example, the icons 113 are arranged in a 2x3 grid, while additional icons 113 may be accessible if a user scrolls down to look and see what is available. However, one of skill in the art would understand that variations thereon may be acceptable for the purposes provided. The icons 113 may be sized for ease of selection by a variety of users. The user interface 105 may be particularly advantageous in dirty conditions, low-light conditions, and the like. The icons 113 may be understood to be pictographic representations of tester functions which are programmed to allow navigation. In other words, a technician or operator of the battery tester may tap the icon to navigate through tester functionality. The icons 113 may guide access to (but are not limited to) testing specific navigation 115 and other tester functionality 117, in various embodiments.

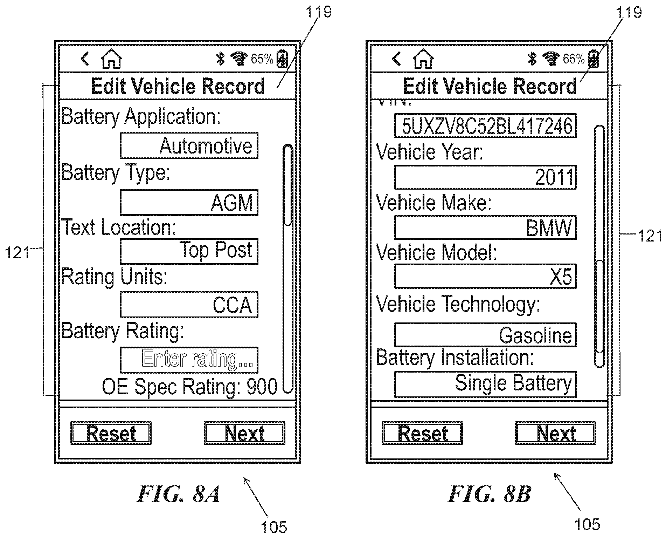

According to the present invention, the icons 113 are used to navigate to the next user interface screen of user interface 105, which comprises interfaces specific to operation of the battery tester and its functionality. For example, Figs. 7-18D show a number of user interfaces relating to battery tester functionality. On the top of each user interface screen as shown in Figs. 7- 18D, is a number of icons. The icons, from left to right, may be understood to facilitate the following functionality when selected (tapped) by a user: navigate back, go to the home (icon grid) screen, Bluetooth connection status, wireless connection status and strength (which may, for example, show as disconnected (e.g. Figs. 6-7) or with an ! next to connection strength (e.g. Figs. 8A-8B)), and battery charge status (both by percentage and icon visualization (e.g. a cylindrical battery icon having varying "fill" levels)). Some of these indicators may likewise be seen in Fig. 6. In various embodiments, some icons may generally be identified as tester battery status 122 and tester connectivity status 120 indicators.

In Fig. 7, a vehicle record interface 119 of the user interface 105 is shown. Descriptions of the fields to be populated may be seen on a left-hand side of the interface, while the populated field may be seen on a right-hand side. These fields may comprise vehicle attributes 121. The entries may be populated by selection of drop-down options. Alternatively, the entries may be populated by activating onboard tester functionality. Entry fields (vehicle record interface 119) may continue beyond a bottom of the screen, therefore a scroll bar may indicate to the user that further information may be entered, for example, by swiping up on the display to reveal further fields. Touch-interface buttons are provided along the bottom of the user interface to "reset" (clear the fields) or "next" (move forward in the interface). Figs. 8A and 8B show another user interface 105 having a vehicle records interface 119 for inputting vehicle record information (for example, into vehicle attributes 121), according to various embodiments. The interfaces of Figs. 7, 8A, and 8B may be used, in various embodiments, where the battery tester is connected to a battery provided in a vehicle.

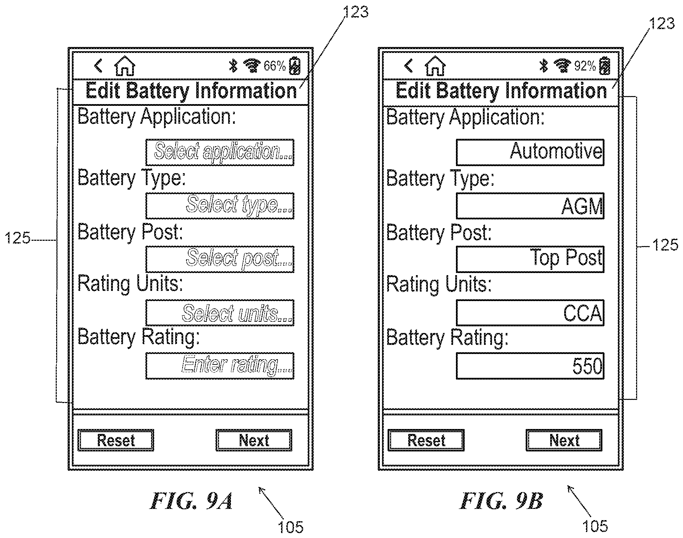

The user interface 105 may further comprise a battery record interface 123. Battery record interface 123 may comprise fields for battery attributes 125. As example embodiments, Figs. 9A and 9B show a battery record interface 123 for editing battery information. This interface may allow for entry of battery information 125, for example, by selecting the field and tapping a pre-populated option. For example, in Fig. 9A a user may touch the screen where "select application" is filled, and an option for "automotive" may appear in a drop-down manner. Results of selections are shown in Fig. 9B. Again, the user may reset or move forward in the interface 123 by selection of the "reset" or "next" buttons, respectively. This user interface may be encountered, for example, but not limited to, where the tester is used to test a battery outside of a vehicle.

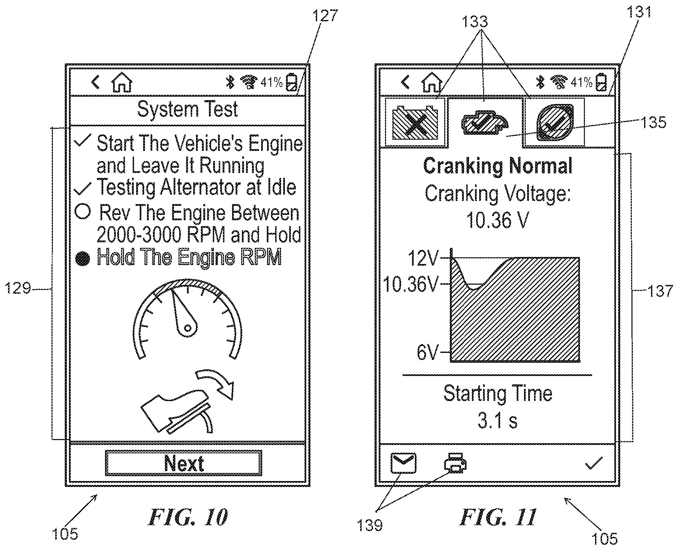

Fig. 10 illustrates a user interface of a battery tester 105 showing a battery or vehicle system testing interface 127. As can be seen, a number of instructions (user instructions 129) are displayed to the operator. The user testing interface 127 may progress through the instructions 129 as the action is performed by the operator. Alternatively, the interface may change display dynamically as the action is performed by the operator. Once the tasks are performed, the user may select "next" to proceed, for example, to testing results.

Figs. 11-18D show various embodiments of a testing results user interface 131. In the illustrated example, results are given as to three testing metrics (three-stage top navigation 133). Although more or fewer result metrics may be displayed. Along the top of the screen (below the "back," "home," "Bluetooth," "wireless," and "battery" selections shown), three icons, including a red battery, green engine, and green circle in a leaf are seen ("three-stage top navigation") 133. These three icons allow a user to navigate between results options, as well as obtain a quick overview of battery health metrics. At a bottom of a testing results user interface 131 user output icons 139 may be seen. These may allow for selection of delivery of results information by, for example, email or printing, in various embodiments.

As shown in Figs. 11, 12, and 13, looking to the top navigation of the three-stage top navigation, a user may immediately ascertain there are issues with, for example, the battery reserve capacity necessitating replacement, but engine cranking and charge may be normal.

Fig. 11 shows a cranking results interface 135 which may include a cranking data display 137. For example, the display 137 may show a graph of results of a cranking test. For example, Fig. 11 results display 137 may show a cranking result having a voltage curve and assessment (this may allow the "engine" icon to display as "green" with a word result below of "Cranking Normal"). A cranking voltage may be seen as well as a voltage test curve. While the icon and interface may be optionally shown in green to reflect a normal cranking result, alternative colors may be used to reflect poorer test results. This may allow for at-a-glance summaries of battery health metrics by way of the top three-icon navigation described above.

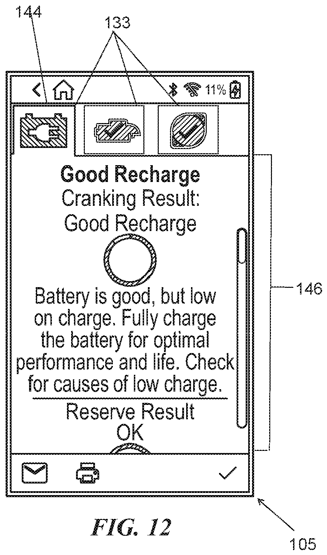

Fig. 12 shows the user interface 105 having a recharge testing results interface 144. The testing results interface 144 may likewise provide results interface data display 146. In various embodiments, the interface display 146 may include the recharge relative to a cranking result which may be visualized as a color (for example, green) and an icon (almost-full ring). A diagnosis may be seen below the ring, with further diagnostic details provided, including reserve result.

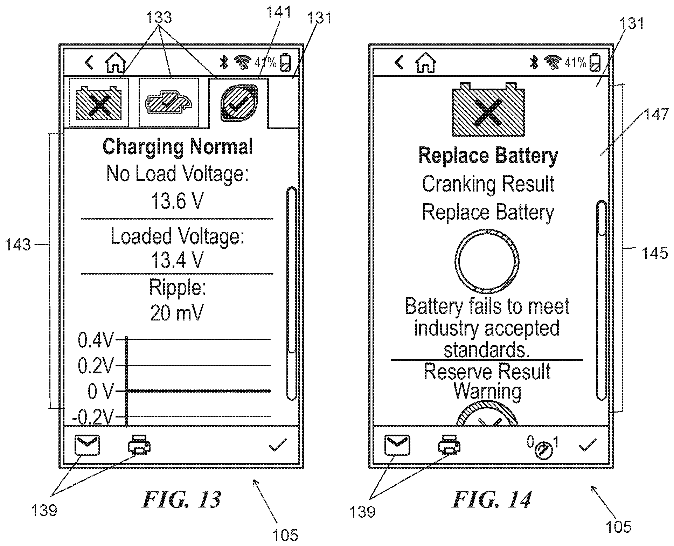

In Fig. 13, the circle in a leaf icon portion of the three-stage top navigation 133 may be selected (note the icon may for example be green and the coloring may be updated to reflect battery health-e.g. if charging is abnormal it may appear red) to display another battery results interface 131 of the battery tester user interface 105. In various embodiments, this interface may be a charging results user interface 141. The charging results user interface 141 may comprise a number of charging results user interface elements 143. The charging test results of Fig. 13 may include a "charging normal" assessment, no load and loaded voltage values, and ripple value, as well as a graph of the test results.

Again, these results may be navigable with minimum effort by the tester by using a three-stage top navigation 133 allowing for easily-accessible information summary. While three icons are used, more or less may be within the scope of this disclosure. In addition, while particular colors (green, red) may be used, others (purple, blue, grey, etc.) should be contemplated as within the scope of this disclosure. In addition, while particular pictographic shapes are used (engine, leaf, ring, battery, etc.) alternatives (squares, other shapes) should be contemplated as within the scope of this disclosure.

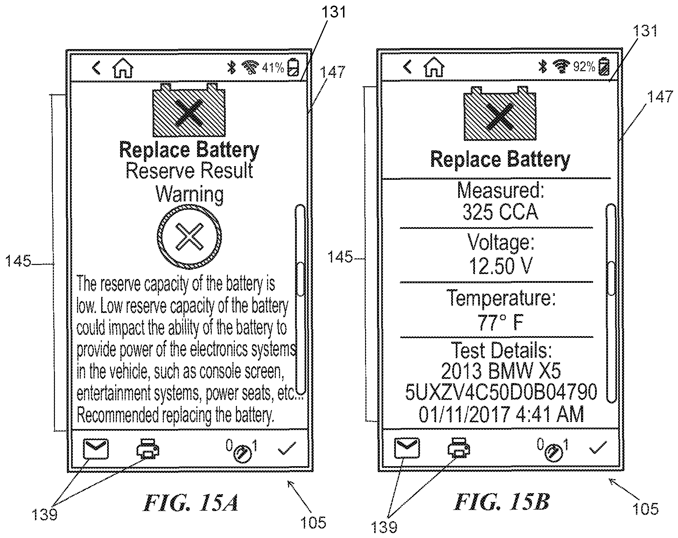

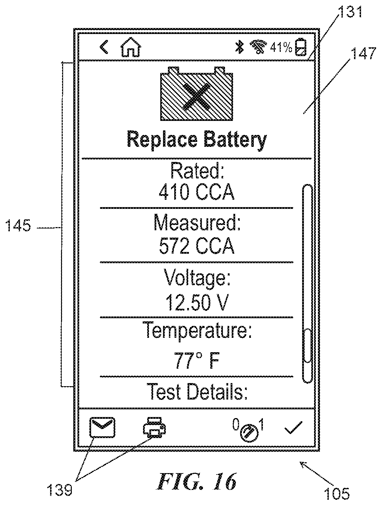

Fig. 14 shows a user results interface 131 summary interface 147 displaying or communicating to a user to replace a battery by way of a battery health summary display 145. In Fig. 14, the user interface comprises a ring representing battery health. Figs. 15A-15B illustrate more details regarding information relating to the reserve capacity of the battery. Fig. 16 illustrates a quick reference of information regarding the tested battery and rated metrics on the user interface 105. In each of these interfaces, there may be further information to be obtained by scrolling down (i.e. dragging a user finger from bottom to top of the interface). While scrolling down is described herein, alternative navigation techniques such as side-scrolling may be contemplated as within the scope of this disclosure.

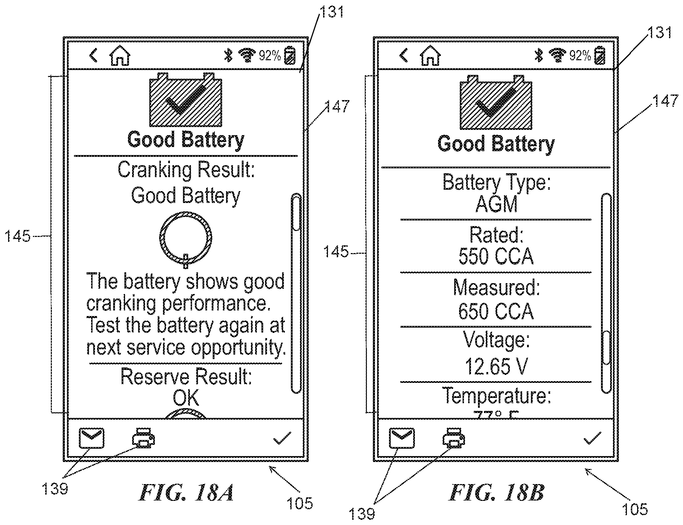

Along the bottom of the user interface 105, for example, in Figs. 11-18D, a number of icons are visible. These icons may prompt a user to send information such as results via email, to print results, (together, 139) to repeat a test, or to accept the results, according to various examples of embodiments. Various additional or alternative options or fewer options are within the scope of this disclosure.

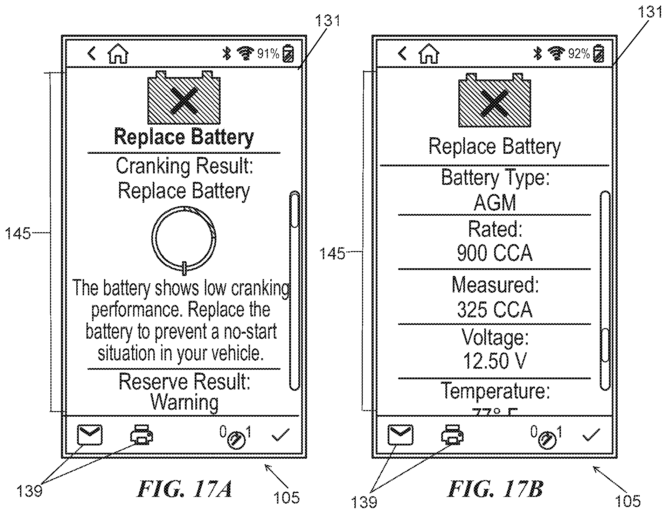

Figs. 17A and 17B provide two further examples of embodiments of the testing user interface 131 having data interface features 145. Fig. 17A shows a ring visualization of poor cranking results and the recommendation to replace the battery. Fig. 17B shows a visualization of results, base values, and a replacement recommendation as part of the data interface features 143.

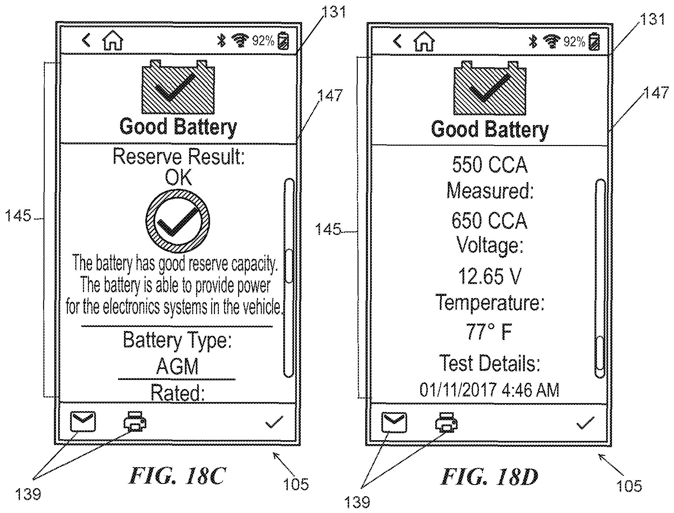

Figs. 18A through 18D show a number of additional user interface 105 visualizations on battery results user interface 131 results summary interface 147 displaying battery testing results information 145, according to various examples of embodiments. In Fig. 18A a "good battery" cranking result is shown with a ring visualization. Similarly, 18A may be understood to show an "ok" reserve result including a ring visualization. A user may, for example, scroll down to see further results. Similarly, Fig. 18B may be seen to include a "good battery" diagnosis with a battery type, rating, measured amount, voltage, and temperature. Again, the interface 147 may allow for scrolling down to obtain further information 145. Fig. 18C shows a view of a report of a reserve result. A checkmark (which may, in various embodiments, be green) as shown may indicate to the user that the battery has a good reserve capacity. Fig. 18D shows a further view of the scrolled result of Fig. 18B.

Fig. 19 shows a front and back of a battery tester 101 having a screen 103 displaying a user interface 105 according to various examples of embodiments. As stated previously, the battery tester may be held with one hand while the user interface is operated. In addition, a mobile device 106 may be seen.

Fig. 20 shows a workflow for interaction of the user interface, according to various embodiments. First, in step S201, a user may hold the tester in one hand. Then, in step S203, the user may swipe up on the display screen to open the testing application user interface. Next, in step S205, the user interface icon grid may be displayed. Then, in step S207 data entry may be displayed (for example, to populate vehicle information and/or battery information) and/or instructions for testing may be displayed to the user. This step may populate instructions for the testing as shown and described in the example above. Next, in step S209, the results summary may be displayed. The three-part navigation may likewise in alternative embodiments be shown to display different types of testing results. In step S211, the user interface may likewise display transmittal options for sending testing results. In various embodiments, transmittal options may be part of the results interface. In order to navigate the interface, the user may tap, scroll, or otherwise interact with a touch-sensitive display screen provided on the battery tester.

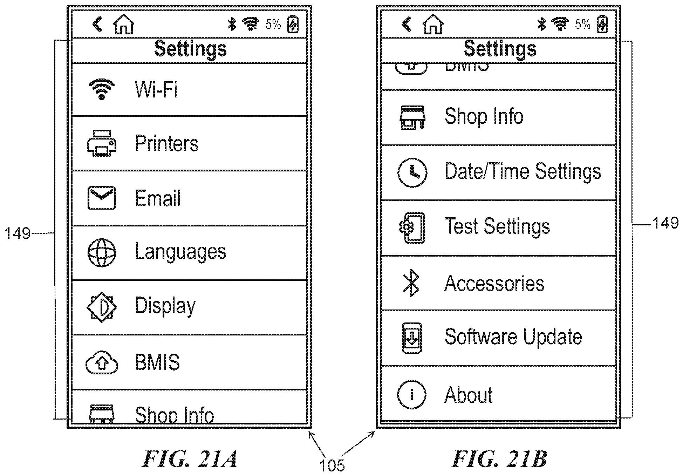

Figs. 21A and 21B show a user interface 105 featuring settings configuration 149, according to various embodiments. A user may scroll down to see the features of 20B from the interface of 21A. The settings user interface options 149 may include: wireless connection settings, printing, emailing (results transmittal), language (user interface display language), display, battery management information systems (BMIS), shop information, date/time settings, test settings, accessories (including Bluetooth settings), software update, and information about the tester.

The user interface for a battery tester described herein has a number of advantages. For example, the user interface may be navigable while holding the device in one hand. The user interface may be simple to navigate, allowing for quick use during battery testing. The user interface may facilitate the display of a range of testing information without requiring further navigation, printing, and the like.

It should be noted that references to relative positions (e.g., "top" and "bottom") in this description are merely used to identify various elements as are oriented in the Figures. It should be recognized that the orientation of particular components may vary greatly depending on the application in which they are used.

For the purpose of this disclosure, the term "coupled" means the joining of two members directly or indirectly to one another. Such joining may be stationary in nature or moveable in nature. Such joining may be achieved with the two members or the two members and any additional intermediate members being integrally formed as a single unitary body with one another or with the two members or the two members and any additional intermediate members being attached to one another. Such joining may be permanent in nature or may be removable or releasable in nature.

It is also important to note that the construction and arrangement of the system, methods, and devices as shown in the various examples of embodiments is illustrative only. Although only a few embodiments have been described in detail in this disclosure, those skilled in the art who review this disclosure will readily appreciate that many modifications are possible (e.g., variations in sizes, dimensions, structures, shapes and proportions of the various elements, values of parameters, mounting arrangements, use of materials, colors, orientations, etc.) without materially departing from the novel teachings and advantages of the subject matter recited. For example, elements shown as integrally formed may be constructed of multiple parts or elements show as multiple parts may be integrally formed, the operation of the interfaces may be reversed or otherwise varied, the length or width of the structures and/or members or connector or other elements of the system may be varied, the nature or number of adjustment positions provided between the elements may be varied (e.g. by variations in the number of engagement slots or size of the engagement slots or type of engagement). The order or sequence of any algorithm, process, or method steps may be varied or re-sequenced according to alternative embodiments. Likewise, some algorithm or method steps described may be omitted, and/or other steps added.

The technical effects and technical problems in the specification are exemplary and are not limiting. It should be noted that the embodiments described in the specification may have other technical effects and can solve other technical problems. Aspects of the method described herein are implemented on a software system running on a computer system. To this end, the methods and system may be implemented in, or in association with, a general-purpose software package or a specific purpose software package. As a specific, non-limiting example, the device could be a battery tester having a user interface in communication with a cloud storage database and/or mobile device.

The software system described herein may include a mixture of different source codes. The system or method herein may be operated by computer-executable instructions, such as but not limited to, program modules, executable on a computer. Examples of program modules include, but are not limited to, routines, programs, objects, components, data structures, and the like which perform particular tasks or implement particular instructions. The software system may also be operable for supporting the transfer of information within a network.

While the descriptions may include specific devices or computers, it should be understood the system and/or method may be implemented by any suitable device (or devices) having suitable computational means. This may include programmable special purpose computers or general-purpose computers that execute the system according to the relevant instructions. The computer system or portable electronic device can be an embedded system, a personal computer, notebook computer, server computer, mainframe, networked computer, workstation, handheld computer, as well as now known or future developed mobile devices, such as for example, a personal digital assistant, cell phone, smartphone, tablet computer, mobile scanning device, and the like. Other computer system configurations are also contemplated for use with the communication system including, but not limited to, multiprocessor systems, microprocessor-based or programmable electronics, network personal computers, minicomputers, smart watches, and the like. Preferably, the computing system chosen includes a processor suitable for efficient operation of one or more of the various systems or functions or attributes of the communication system described.

The system or portions thereof may also be linked to a distributed computing environment, where tasks are performed by remote processing devices that are linked through a communication network(s). To this end, the system may be configured or linked to multiple computers in a network including, but not limited to, a local area network, wide area network, wireless network, and the Internet. Therefore, information, content, and data may be transferred within the network or system by wireless means, by hardwire connection, or combinations thereof. Accordingly, the devices described herein communicate according to now known or future developed pathways including, but not limited to, wired, wireless, and fiber-optic channels.

In one or more examples of embodiments, data may be stored remotely (and retrieved by the application) or may be stored locally on a user's device in a suitable storage medium. Data storage may be in volatile or non-volatile memory. Data may be stored in appropriate computer-readable medium including read-only memory, random-access memory, CD-ROM, CD-R, CD-RW, magnetic tapes, flash drives, as well as other optical data storage devices. Data may be stored and transmitted by and within the system in any suitable form. Any source code or other language suitable for accomplishing the desired functions described herein may be acceptable for use.

Furthermore, the computer or computers or portable electronic devices may be operatively or functionally connected to one or more mass storage devices, such as but not limited to, a hosted database or cloud-based storage.

The system may also include computer-readable media which may include any computer-readable media or medium that may be used to carry or store desired program code that may be accessed by a computer. The invention can also be embodied as computer-readable code on a computer-readable medium. To this end, the computer-readable medium may be any data storage device that can store data. The computer-readable medium can also be distributed over a network-coupled computer system so that the computer-readable code is stored and executed in a distributed fashion.

## Claims

1. A battery tester (101) comprising two tester cables (102) attached to a housing of said battery tester (101), said battery tester (101) being configured to electrically connect by said two tester cables (102) to terminals of a battery to be tested, said battery tester (101) comprising a computing device and a screen, the computing device being configured to display on the screen a user interface (105) for battery testing allowing for one-handed interaction with the user interface (105), wherein the user interface (105) is vertically oriented, i.e. portrait orientation, and the battery tester (101) is sized to be held one-handed;
the user interface (105) comprising a series of interfaces:
- a first interface comprising a plurality of icons (113), each of the plurality of icons (113) corresponding to a test condition or a tester functionality, wherein one of the plurality of icons (113) corresponds to a test condition to begin a test;
- a testing interface (127) comprising a number of instructions (129), the testing interface (127) configured to dynamically update based on the completion of one or more testing steps, and wherein selection of the one of the plurality of icons (113) in the first interface corresponding to the test condition displays the testing interface (127); and
- a results interface (131, 135, 141, 144), having a three-stage top navigation (133) and health summary, the three-stage top navigation (133) for reporting battery health metrics, wherein completion of one or more tests displays the results interface (131, 135, 141, 144), and wherein the three-stage top navigation (133) provides along a top of the results interface (131, 135, 141, 144) three icons for allowing a user to navigate between results options and obtain an overview of the battery health metrics.

2. The battery tester (101) of claim 1,
wherein one or more icons of the three-stage top navigation (133) comprises a cranking result or a charging result.

3. The battery tester (101) of claim 2,
wherein selection of one or more icons of the three-stage top navigation (133) presents a battery replacement recommendation.

4. The battery tester (101) of one of claims 1 to 3,
wherein selection of one icons of the three-stage top navigation (133) provides a testing results summary interface.

5. The battery tester (101) of claim 4,
wherein viewing of the testing results summary interface is achieved by scrolling downward on the tester user interface (105).

6. The battery tester (101) of one of claims 1 to 5,
further comprising a vehicle record interface (119), the vehicle record interface (119) having a plurality of fields for inputting vehicle information, wherein the interface may be populated by a user or tester-obtained data.

7. The battery tester (101) of one of claims 1 to 6,
wherein one icon of the three-stage top navigation comprises a cranking result.

8. A method for battery health data capture and display allowing for one-handed interaction with a user interface (105) displayed on a screen, the method comprising:
- holding a battery tester (101) comprising two tester cables (102) attached to a housing of said battery tester (101), said battery tester (101) being electrically connected to terminals of a battery to be tested by said tester cables (102), the battery tester (101) having the screen displaying the user interface (105) in a vertical orientation, i.e. portrait orientation, the battery tester (101) sized to be held one-handed;
- displaying a first interface comprising a plurality of icons (113), each of the plurality of icons (113) corresponding to a test condition or a tester functionality;
- selecting one of a plurality of icons (113) displayed on the user interface (105) corresponding to a test condition to begin a test;
- displaying on the user interface (105) a testing interface (127) comprising a number of instructions (129), said testing interface (127) dynamically updating based on the completion of one or more testing steps;
- upon completion of one or more tests, displaying on the user interface (105) a results interface (131, 135, 144) having a three-stage top navigation (133) and health summary, the three-stage top navigation (133) corresponding to different battery health information, wherein the three-stage top navigation (133) provides along a top of the results interface (131, 135, 141, 144) three icons for allowing a user to navigate between results options and obtain an overview of the battery health metrics; and
- selecting on the user interface (105) one or more icons of the three-stage top navigation (133) to display a results summary and recommendation regarding battery health.

9. The method of claim 8,
further comprising populating on the user interface (105) a vehicle information interface, the vehicle information interface optionally being populated by manual entry.

10. The method of claim 8 or 9,
wherein the screen of the battery tester (101) is a touchscreen.

11. The method of claim 10,
wherein one icon of the three-stage top navigation (133) comprises a cranking result.

## Patentansprüche

1. Batterietester (101), der zwei Testerkabel (102) umfasst, die an einem Gehäuse des Batterietesters (101) befestigt sind,
wobei der Batterietester (101) dazu ausgelegt ist, über die zwei Testerkabel (102) mit Anschlüssen einer zu testenden Batterie elektrisch verbunden zu sein,
wobei der Batterietester (101) eine Datenverarbeitungsvorrichtung und einen Bildschirm umfasst,
wobei die Datenverarbeitungsvorrichtung dazu ausgelegt ist, auf dem Bildschirm eine Benutzerschnittstelle (105) zum Testen einer Batterie anzuzeigen, die eine Interaktion mit der Benutzerschnittstelle (105) mit einer Hand erlaubt,
wobei die Benutzerschnittstelle (105) vertikal ausgerichtet ist, d. h. in einer Hochformatausrichtung, und der Batterietester (101) dimensioniert ist, um mit einer Hand gehalten zu werden;
wobei die Benutzerschnittstelle (105) eine Reihe von Schnittstellen umfasst:
- eine erste Schnittstelle, die eine Vielzahl von Symbolen (113) umfasst, wobei jedes der Vielzahl von Symbolen (113) einer Testbedingung oder einer Testerfunktionalität entspricht,
wobei eines der Vielzahl von Symbolen (113) einer Testbedingung zum Beginnen eines Tests entspricht;
- eine Testschnittstelle (127), die eine Anzahl von Anweisungen (129) umfasst,
wobei die Testschnittstelle (127) dazu ausgelegt ist, auf Basis des Abschlusses von einem oder mehreren Testschritten dynamisch aktualisiert zu werden, und
wobei eine Auswahl des einen der Vielzahl von Symbolen (113), in der ersten Schnittstelle, das der Testbedingung entspricht, die Testschnittstelle (127) anzeigt; und
- eine Ergebnisschnittstelle (131, 135, 141, 144), die eine dreistufige obere Navigation (133) und eine Zustandsübersicht aufweist, wobei die dreistufige obere Navigation (133) dem Melden von Batteriezustandsmetriken dient,
wobei ein Abschluss von einem oder mehreren Tests die Ergebnisschnittstelle (131, 135, 141, 144) anzeigt und
wobei die dreistufige obere Navigation (133) entlang einer Oberseite der Ergebnisschnittstelle (131, 135, 141, 144) drei Symbole anzeigt, die es erlauben, dass ein Benutzer zwischen Ergebnisoptionen navigiert und einen Überblick über die Batteriezustandsmetriken erhält.

2. Batterietester (101) nach Anspruch 1,
wobei ein oder mehrere Symbole der dreistufigen oberen Navigation (133) ein Anlassergebnis oder ein Ladeergebnis umfassen.

3. Batterietester (101) nach Anspruch 2,
wobei eine Auswahl von einem oder mehreren Symbolen der dreistufigen oberen Navigation (133) eine Batterieaustauschempfehlung präsentiert.

4. Batterietester (101) nach einem der Ansprüche 1 bis 3,
wobei eine Auswahl von einem Symbolen der dreistufigen oberen Navigation (133) eine Testergebnisübersichtsschnittstelle bereitstellt.

5. Batterietester (101) nach Anspruch 4,
wobei ein Ansehen der Testergebnisübersichtsschnittstelle durch Scrollen auf der Testerbenutzerschnittstelle (105) nach unten erreicht wird.

6. Batterietester (101) nach einem der Ansprüche 1 bis 5,
der ferner eine Fahrzeugdatensatzschnittstelle (119) umfasst,
wobei die Fahrzeugdatensatzschnittstelle (119) zum Eingeben von Fahrzeuginformationen eine Vielzahl von Feldern aufweist,
wobei die Schnittstelle durch einen Benutzer oder mit vom Tester erhaltenen Daten gefüllt werden kann.

7. Batterietester (101) nach einem der Ansprüche 1 bis 6,
wobei ein Symbol der dreistufigen oberen Navigation ein Anlassergebnis umfasst.

8. Verfahren für eine Erfassung und Anzeige von Batteriezustandsdaten für eine Interaktion mit einer Benutzerschnittstelle (105), die auf einem Bildschirm angezeigt wird, mit einer Hand,
wobei das Verfahren Folgendes umfasst:
- Halten eines Batterietesters (101), der zwei Testerkabel (102) umfasst, die an einem Gehäuse des Batterietesters (101) befestigt sind, wobei der Batterietester (101) über die zwei Testerkabel (102) mit Anschlüssen einer zu testenden Batterie elektrisch verbunden ist, wobei der Batterietester (101) den Bildschirm aufweist, auf dem die Benutzerschnittstelle (105) in einer vertikalen Ausrichtung, d. h. in einer Hochformatausrichtung, angezeigt wird,
wobei der Batterietester (101) dimensioniert ist, um mit einer Hand gehalten zu werden;
- Anzeigen einer ersten Schnittstelle, die eine Vielzahl von Symbolen (113) umfasst,
wobei jedes der Vielzahl von Symbolen (113) einer Testbedingung oder einer Testerfunktionalität entspricht;
- Auswählen von einem einer Vielzahl von Symbolen (113), die auf der Benutzerschnittstelle (105) angezeigt werden, das einer Testbedingung zum Beginnen eines Tests entsprechen;
- Anzeigen einer Testschnittstelle (127), die eine Anzahl von Anweisungen (129) umfasst, auf der Benutzerschnittstelle (105),
wobei die Testschnittstelle (127) auf Basis des Abschlusses von einem oder mehreren Testschritten dynamisch aktualisiert wird,
- nach Abschluss von einem oder mehreren Tests Anzeigen einer Ergebnisschnittstelle (131, 135, 144), die eine dreistufige obere Navigation (133) und eine Zustandsübersicht aufweist, auf der Benutzerschnittstelle (105),
wobei die dreistufige obere Navigation (133) verschiedenen Batteriezustandsinformationen entspricht,
wobei die dreistufige obere Navigation (133) entlang einer Oberseite der Ergebnisschnittstelle (131, 135, 141, 144) drei Symbole anzeigt, die es erlauben, dass ein Benutzer zwischen Ergebnisoptionen navigiert und einen Überblick über die Batteriezustandsmetriken erhält; und
- Auswählen von einem oder mehreren Symbolen der dreistufigen oberen Navigation (133) auf der Benutzerschnittstelle (105), um eine Ergebnisübersicht sowie eine Empfehlung hinsichtlich des Batteriezustands anzuzeigen.

9. Verfahren nach Anspruch 8,
das ferner das Füllen der Benutzerschnittstelle (105) einer Fahrzeuginformationsschnittstelle umfasst,
wobei die Fahrzeuginformationsschnittstelle wahlweise durch eine manuelle Eingabe gefüllt wird.

10. Verfahren nach Anspruch 8 oder 9,
wobei der Bildschirm des Batterietesters (101) ein Touchscreen ist.

11. Verfahren nach Anspruch 10,
wobei ein Symbol der dreistufigen oberen Navigation (133) ein Anlassergebnis umfasst.

## Revendications

1. Testeur de batterie (101) comprenant deux câbles de testeur (102) fixés à un boîtier dudit testeur de batterie (101), ledit testeur de batterie (101) étant configuré pour être relié électriquement par lesdits deux câbles de testeur (102) à des bornes d'une batterie à tester, ledit testeur de batterie (101) comprenant un dispositif informatique et un écran, le dispositif informatique étant configuré pour afficher sur l'écran une interface utilisateur (105) pour un test de batterie permettant une interaction à une main avec l'interface utilisateur (105), dans lequel l'interface utilisateur (105) est orientée verticalement, c'est-à-dire dans une orientation en portrait, et le testeur de batterie (101) est dimensionné pour être porté à une main ;
l'interface utilisateur (105) comprenant une série d'interfaces :
- une première interface comprenant une pluralité d'icônes (113), chacune de la pluralité d'icônes (113) correspondant à une condition de test ou à une fonctionnalité de testeur, dans lequel l'une de la pluralité d'icônes (113) correspond à une condition de test pour commencer un test ;
- une interface de test (127) comprenant un certain nombre d'instructions (129), l'interface de test (127) étant configurée pour être mise à jour dynamiquement sur la base de l'achèvement d'une ou plusieurs étapes de test, et dans lequel la sélection de l'une de la pluralité d'icônes (113) dans la première interface correspondant à la condition de test affiche l'interface de test (127) ; et
- une interface de résultats (131, 135, 141, 144), ayant une navigation supérieure à trois étages (133) et un résumé de santé, la navigation supérieure à trois étages (133) signalant des mesures de santé de batterie, dans lequel l'achèvement d'un ou plusieurs tests affiche l'interface de résultats (131, 135, 141, 144), et dans lequel la navigation supérieure à trois étages (133) fournit le long d'une partie supérieure de l'interface de résultats (131, 135, 141, 144) trois icônes pour permettre à un utilisateur de naviguer entre des options de résultats et d'obtenir une vue d'ensemble des mesures de santé de batterie.

2. Testeur de batterie (101) selon la revendication 1,
dans lequel une ou plusieurs icônes de la navigation supérieure à trois étages (133) comprennent un résultat de démarrage ou un résultat de charge.

3. Testeur de batterie (101) selon la revendication 2,
dans lequel la sélection d'une ou plusieurs icônes de la navigation supérieure à trois étages (133) présente une recommandation de remplacement de batterie.

4. Testeur de batterie (101) selon l'une des revendications 1 à 3,
dans lequel la sélection d'une icône de la navigation supérieure à trois étages (133) fournit une interface de résumé de résultats de test.

5. Testeur de batterie (101) selon la revendication 4,
dans lequel la visualisation de l'interface de résumé de résultats de test est obtenue en faisant défiler vers le bas l'interface utilisateur de testeur (105).

6. Testeur de batterie (101) selon l'une des revendications 1 à 5, comprenant en outre une interface d'enregistrement de véhicule (119), l'interface d'enregistrement de véhicule (119) ayant une pluralité de champs pour saisir des informations de véhicule, dans lequel l'interface peut être remplie par un utilisateur ou des données obtenues par testeur.

7. Testeur de batterie (101) selon l'une des revendications 1 à 6,
dans lequel une icône de la navigation supérieure à trois étages comprend un résultat de démarrage.

8. Procédé de capture et d'affichage de données de santé de batterie permettant une interaction à une main avec une interface utilisateur (105) affichée sur un écran, le procédé comprenant :
- le fait de porter un testeur de batterie (101) comprenant deux câbles de testeur (102) fixés à un boîtier dudit testeur de batterie (101), ledit testeur de batterie (101) étant relié électriquement à des bornes d'une batterie à tester par lesdits câbles de testeur (102), le testeur de batterie (101) ayant l'écran affichant l'interface utilisateur (105) dans une orientation verticale, c'est-à-dire une orientation en portrait, le testeur de batterie (101) étant dimensionné pour être porté à une main ;
- l'affichage d'une première interface comprenant une pluralité d'icônes (113), chacune de la pluralité d'icônes (113) correspondant à une condition de test ou à une fonctionnalité de testeur ;
- la sélection de l'une d'une pluralité d'icônes (113) affichées sur l'interface utilisateur (105) correspondant à une condition de test pour commencer un test ;
- l'affichage sur l'interface utilisateur (105) d'une interface de test (127) comprenant un certain nombre d'instructions (129), ladite interface de test (127) étant mise à jour dynamiquement sur la base de l'achèvement d'une ou plusieurs étapes de test ;
- après l'achèvement d'un ou plusieurs tests, l'affichage sur l'interface utilisateur (105) d'une interface de résultats (131, 135, 144) ayant une navigation supérieure à trois étages (133) et un résumé de santé, la navigation supérieure à trois étages (133) correspondant à différentes informations de santé de batterie, dans lequel la navigation supérieure à trois étages (133) fournit le long d'une partie supérieure de l'interface de résultats (131, 135, 141, 144) trois icônes pour permettre à un utilisateur de naviguer entre des options de résultats et d'obtenir une vue d'ensemble des mesures de santé de batterie ; et
- la sélection sur l'interface utilisateur (105) d'une ou plusieurs icônes de la navigation supérieure à trois étages (133) pour afficher un résumé de résultats et une recommandation concernant la santé de la batterie.

9. Procédé selon la revendication 8,
comprenant en outre le remplissage sur l'interface utilisateur (105) d'une interface d'informations de véhicule, l'interface d'informations de véhicule étant facultativement remplie par une saisie manuelle.

10. Procédé selon la revendication 8 ou 9,
dans lequel l'écran du testeur de batterie (101) est un écran tactile.

11. Procédé selon la revendication 10,
dans lequel une icône de la navigation supérieure à trois étages (133) comprend un résultat de démarrage.
